Europäisches Patentamt

European Patent Office

Office européen des brevets

(11) Publication number:

**0 228 183**
A2

## (12) EUROPEAN PATENT APPLICATION

(21) Application number: 86309132.8

(22) Date of filing: 21.11.86

(51) Int. Cl.⁴: **H 01 L 21/24**

(30) Priority: 27.11.85 JP 266951/85

(43) Date of publication of application: 08.07.87
Bulletin 87/28

(84) Designated Contracting States: **DE FR GB**

(71) Applicant: **Kabushiki Kaisha Toshiba, 72, Horikawa-cho
Saiwai-ku, Kawasaki-shi Kanagawa-ken 210 (JP)**

(72) Inventor: **Noguchi, Tatsuo, c/o Patent Div. Toshiba
Corporation Prin. Office, 1-1 Shibaura 1-chome
Minato-ku Tokyo (JP)**

(74) Representative: **Freed, Arthur Woolf et al, MARKS &
CLERK 57-60 Lincoln's Inn Fields, London WC2A 3LS
(GB)**

(54) **Method for manufacturing semiconductor device.**

(57) This invention provides a method for manufacturing a
semiconductor device having a semiconductor substrate (21)
comprising the steps of diffusing an impurity into the substrate
(21) to form diffusion region (25, 26) in the substrate (21),
depositing an insulation layer (27) on the semiconductor sub-
strate (21), etching a contact hole (28) through the insulation
layer (27) for exposing a portion of the diffusion region (25,
26), filling the contact hole (28) with a semiconductive layer
(29a), depositing a conductive layer (30) over the entire substrate for connection to the semiconductive layer (29a), and
selectively etching the conductive layer (30) to form a lead.

1

## TITLE OF THE INVENTION
METHOD FOR MANUFACTURING SEMICONDUCTOR DEVICE
## BACKGROUND OF THE INVENTION
### FIELD OF THE INVENTION

This invention relates to a method for manufacturing a semiconductor device. In particular, the invention relates to an improved method for manufacturing a semiconductor device having a connection between the diffusion layer in a semiconductor substrate and interconnection leads.

### DESCRIPTION OF THE PRIOR ART

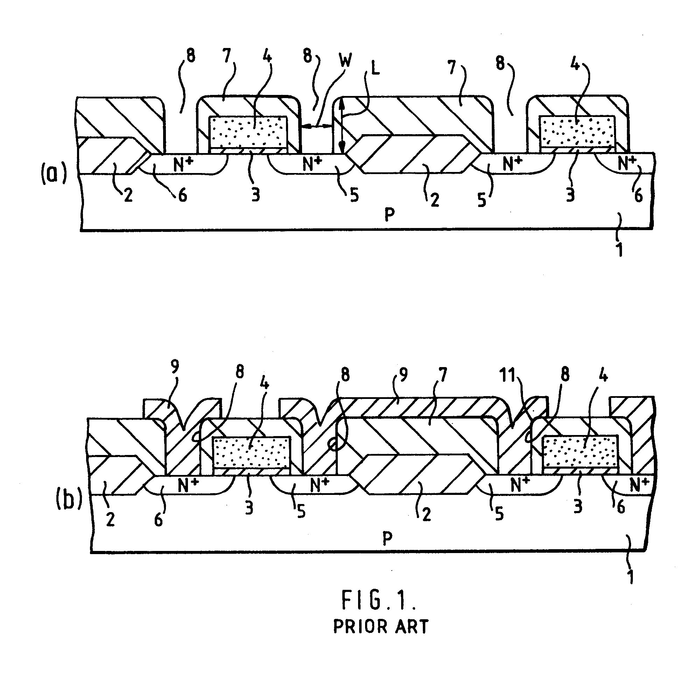

Semiconductor devices are typically fabricated as shown in Figures 1 (a) and (b).

Firstly, as shown in Figure 1 (a), field oxidation layer 2 is formed on the surface of p-type silicon substrate 1. Then, polycrystalline silicon gate electrodes 4 are formed on the substrate through a gate dioxide layer 3 surrounded by field oxidation layer 2.

At this point, N+ type source and drain regions 5 and 6 are formed by the introduction of n-type impurities into the device region using gate electrodes 4 as masks.

Then, after a further intermediate insulating layer 7 is formed over the entire substrate surface, apertures are selectively opened in intermediate insulating layer 7 over the source and drain regions 5 and 6 to form contact holes 8.

Consequently, as shown in Figure 1 (b), after the vapor deposition of an aluminum (Al) layer over the entire substrate, the Al layer is then patterned to form connect leads 9. These leads 9 form the electrical connections to the source and drain regions 5 and 6 through contact holes 8, thus forming the completed semiconductor device.

According to conventional fabrication techniques, however, there are certain problems described as follows. As shown in Figure 1 (a), W is the diameter of a contact hole 8, and L is the thickness of contact hole 8 in the intermediate insulating layer 7. The diameter W of contact hole 8 made by conventional fabrication techniques has become progressively smaller in order to meet trends in micro-circuit miniaturization.

When the thickness L of the intermediate insulating layer 7 also is decreased, the connect lead capacitance increases. To achieve higher packing density in large scale devices, it is necessary to use multi-structured gate electrodes. Consequently, since the thickness of L may not be reduced too much, it is difficult to reduce the L/W ratio by a significant amount.

In the conventional method in which a metallisation layer of an aluminum (Al) is formed in contact holes 8, the following problems arose, when the L/W ratio was increased. The metal did not fill deeply enough into the base of contact holes 8. Crack formations were caused in connect leads 9 which were too thin at the corners 11 of the upper edge of contact holes 8.

A method was considered wherein a thick layer of aluminum (Al) was deposited to avoid this problem. However this method was undesirable because of an accompanying increase in connect lead capacitance.

## SUMMARY OF THE INVENTION

An object of this invention is to provide a method for manufacturing a semiconductor device which can form flat connect leads.

A further object of this invention is to prevent crack formations at the corners along the upper edges of the contact holes and also to prevent increase of the lead capacitance.

This invention provides a method for manufacturing a semiconductor device having a semiconductor substrate comprising the steps of diffusing an impurity into the substrate to form a diffusion region in the substrate, depositing an insulating layer on the semiconductor substrate, etching a contact hole through the insulating layer for exposing the diffusion region, filling the contact hole with a semiconductive layer, depositing a conductive layer over the entire substrate for connecting the semiconductive layer, and selectively etching the conductive layer to form a lead.

In this present invention, two alternative methods are utilized for fabricating the semiconductive layer. The first method is one in which a heat treatment process is used after the contact holes have been formed and a silicon doped metallic layer has been deposited on the insulating layer. As a result of this procedure, silicon is diffused inside a hole in the metallic layer to form a concetrated area of silicon between the interface region and the metallic layer, thereby forming a semiconductive layer inside the contact hole. The second method is one in which metal is deposited on the surface of the insulating layer to fill the hole, a polycrystalline silicon or non-crystalline silicon layer is deposited on the metallic layer and the device is subjected to a further heat treatment process.

4

The heat treatment forms a semiconductive layer, in a manner similar to that described above, by the diffusion of the silicon within the metal into a concentrated area between the interface region and the metal layer in the hole.

### BRIEF DESCRIPTION OF THE DRAWINGS

Figure 1 (a) and (b) show a cross-sectional sequence of the processing steps illustrating the conventional method for manufacturing a semiconductor device.

Figure 2 (a) to (d) show a cross-sectional sequence of processing steps illustrating one method for manufacturing a semiconductor device according to the present invention.

Figure 3 is an explanatory diagram of another method for manufacturing a semiconductor device according to the present invention.

### DETAILED DESCRIPTION OF THE PREFERRED EMBODIMENTS

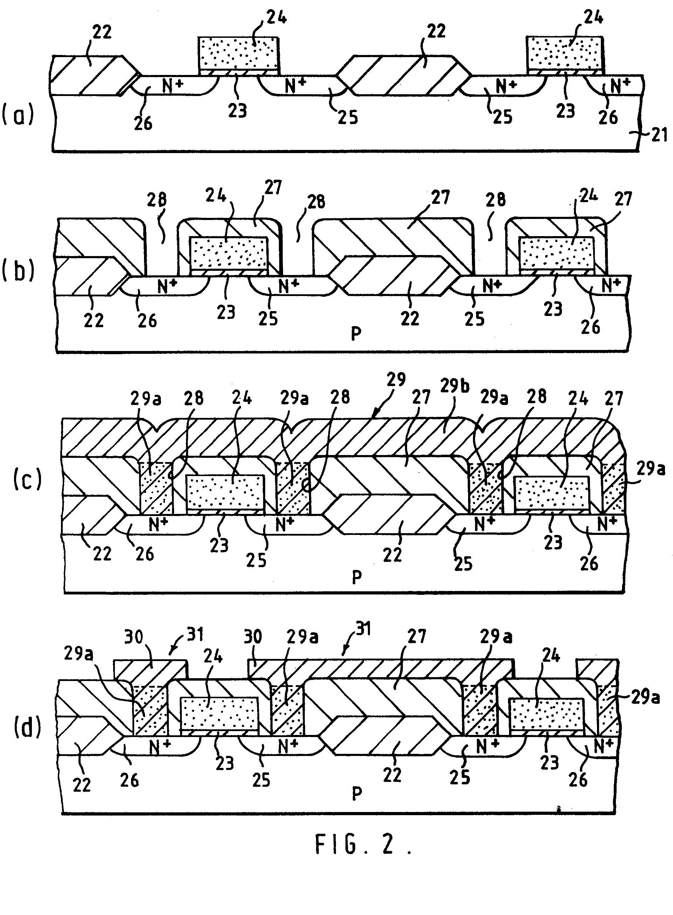

The following is an explanation of a practical embodiment of the present invention, with reference to Figures 2 (a) to (d).

Firstly, as shown in Figure 2 (a), field oxidation layer 22 is formed on the surface of p-type silicon substrate. This is followed by the formation of gate electrodes 24, comprising polycrystalline silicon, through gate dioxide layer 23 into the device region encompassed by field oxidation layer 22.

$N^+$ type source and drain regions 25 and 26 are then formed by the introduction of n-type impurities into the device region by masking gate with electrodes 24.

Subsequent to this, as shown in Figure 2 (b), intermediate insulating layer 27 is formed over the entire substrate surface. This is immediately followed by the formation of contact holes 28 by selectively etching apertures in the intermediate insulating layer 27 over source and drain regions 25 and 26.

Following this, as shown in Figure 2 (c), aluminum (Al) layer 29, doped with approximately 10% silicon, is formed over the entire substrate surface. The thickness of aluminum (Al) layer 29 is approximately the same depth as contact holes 28. The device is then subjected to a heat treatment process at a temperature of about 450$^{o}$C for 30 to 60 minutes. As a result of this process, the silicon within the aluminum is diffused toward the region where Al layer 28 interfaces with silicon substrate 21. Thus, the aluminum (Al) layer within contact holes 28 becomes a silicon layer (semiconductive layer) 29a. Layer 29b in the figure is the aluminum (Al) layer which remains after heat treatment process.

Furthermore, temperature conditions need not be restricted to 450$^{o}$C, but generally can be in the range 400$^{o}$C to 600$^{o}$C. If the temperature is significantly outside this range, however, there will be insufficient silicon diffusion and unsatisfactory results. Also, the silicon layer 29a contains silicon which is above the solid solubility limit of the aluminum (Al).

Next, aluminum (Al) layer 29b is selectively removed by etching, using, for example, hydrochloric acid. However, since the etching rates of Al layer 29b and semiconductive layer 29a are different, semiconductive layer 29a remains in the contact hole. Since the silicon diffused from aluminum (Al) layer 29 is p-type, an n-type material, such as phosphorus, is either diffused or ion implanted into region 29a.

As shown in Figure 2 (c), after the entire surface has been further covered with aluminum (Al) evaporation by vapor deposition, the surface is then patterned to form aluminum (Al) pattern 30, which is in electrical contact with silicon layer 29a.

Connect leads 31 are fabricated from the aluminum (Al) pattern 30 and silicon layer 29a, thus forming the completed semiconductor device.

According to the present invention, after contact holes 28 are opened in intermediate insulating layer 27, and silicon doped aluminum (Al) layer 29 is formed over the entire surface of the substrate, silicon layer 29a is selectively formed inside contact hole 28 by a heat treatment process carried out under prescribed conditions.

Also, connect leads 31 can be formed by overlaying aluminum (Al) pattern 30, which forms the electrical contact with silicon layer 29a, on the upper surface of the silicon layer 29a.

Consequently, even with the large L/W ratios resulting from conventional fabrication methods, silicon layer 29a, part of which forms connect leads 31, can be adequately filled into contact holes 28. Accordingly, crack formations in connect leads 31 at the corners of the upper edge of contact holes 28 can be prevented.

Therefore, connect leads 31 are made flatter and thinner as compared with those of conventionally made devices. The capacitance between connect leads 31 and substrate 21 can be decreased for making intermediate insulating layer 27 thicker. The capacitance between connect leads 31 also can be reduced. Thereby the operational speed of the device may be effectively increased.

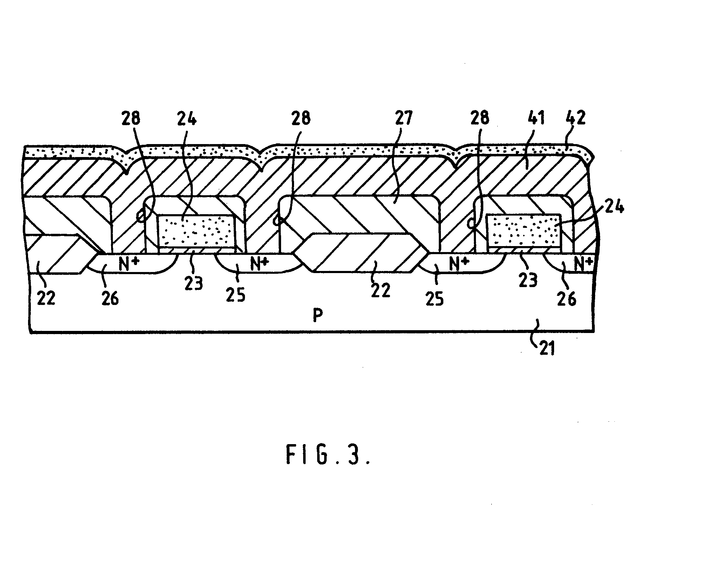

The illustrated embodiment of Figure 2 relates to the diffusion of silicon within the aluminum (Al) layer by heat treatment processing, but is not limited to this process. Another method, as shown in Figure 3, is one in which contact holes 28 are formed in intermediate insulating layer 27. An aluminum (Al) layer 41 is deposited on the entire surface. A polycrystalline silicon layer (or non-crystalline silicon layer) 42 is deposited on Al layer 41. Then the silicon layer is formed inside contact holes 28 by means of a heat treatment process.

Also, in this particular embodiment, aluminum (Al) is used for the metallization, but the process is not restricted to this choice of material. Other metals such as platinum (Pt), tungsten (W), titanium (Ti), cobalt (Co), or tantalum (Ta) can be used.

According to the present invention just described, a method for manufacturing a semiconductor device can provide connect leads with improved flatness without the usual accompanying crack formation or increased lead capacitance side effects.

Various modifications and variations could be made to the invention without departing from the scope or spirit of the invention.

CLAIMS

1. A method for manufacturing a semiconductor device having a semiconductor substrate (21) comprising the steps of:

diffusing an impurity into the substrate (21) to form a diffusion region (25,26) in the substrate (21);

depositing an insulation layer (27) on the semiconductor substrate (21); and

etching a contact hole (28) through the insulation layer (27) for exposing a portion of the diffusion region (25,26); characterized in that

filling the contact hole (28) with a semiconductive layer (29a);

depositing a conductive layer (30) over the entire substrate for connection to the semiconductive layer (29a); and

selectively etching the conductive layer (30) to form a lead.

2. A method for manufacturing a semiconductor device according to claim 1 wherein the step of filling includes the steps of:

depositing a metallic layer (29) including silicon over the entire substrate;

heating the substrate for concentrating the silicon on the surface of the diffusion region (25,26) in the contact hole (28); and

selectively removing the metallic layer (29b) to leave the semiconductive layer (29a) inside the contact hole (28).

3. A method for manufacturing a semiconductor device according to claim 2 wherein the step of heating includes the step of raising the temperature to about 400°C to 600°C.

4. A method for manufacturing a semiconductor device according to claim 2 wherein the step of heating also includes the step of maintaining the temperature at about 450°C for about 30 to 60 minutes.

5. A method for manufacturing a semiconductor device according to claim 1 wherein the step of filling includes the steps of:

depositing a metallic layer (41) on the entire surface of the substrate;

depositing a silicon layer (42) on the metallic layer;

heating the substrate for concentrating the silicon on the surface of the diffusion region (25,26) in the contact hole (28); and

selectively removing the metallic and silicon layers to leave the semiconductive layer (29a) inside the contact hole (28).

6. A method for manufacturing a semiconductor device according to claim 5 wherein the step of heating includes the step of raising the temperature to about 400°C to 600°C.

7. A method for manufacturing a semiconductor device according to claim 2 wherein the step of depositing a metallic layer (29) includes the step of simultaneously

10

depositing a metal and silicon in an amount above the solid solubility limit of the metal.

8. A method for manufacturing a semiconductor device according to claim 1 wherein the step of filling includes the steps of:

selecting a material from the group consisting of aluminum, platinum, tungsten, titanium, cobalt, and tantalum;

depositing the material in the contact hole; and diffusing silicon into the material in the contact hole.

FIG.1.
PRIOR ART

FIG. 2.

FIG.3.